# EUROPEAN PATENT APPLICATION

(11) **EP 4 604 146 A2**
(43) Date of publication of application: **20.08.2025**
(21) Application number: 25158343.1
(22) Date of filing: 17.02.2025
(51) Int. Cl.: H01F 27/02, H01F 27/22, H01F 27/16

(54) **MAGNETIC APPARATUS AND CHARGING DEVICE**

(30) Priority: 18.02.2024 CN 202410183335
(71) Applicant: ABB E-mobility B.V., 2629 JG Delft (NL)
(72) Inventor: ZHANG, Fan, Shenzhen, 518118 (CN); CHEN, Zhiyi, Shenzhen, 518101 (CN); TANG, Yin, Shenzhen, 518052 (CN); YUEN, Kuen Faat, Hong Kong, 000000 (CN)
(74) Representative: Zimmermann & Partner Patentanwälte mbB

(57) **Abstract**

Example of embodiments of the present disclosure relate to a magnetic apparatus and a charging device. The magnetic apparatus comprises: a heat-generating component (10); a housing (20) enclosing an inner space (21) and comprising an opening (22) through which the heat-generating component (10) can enter the inner space (21) so as to be accommodated within the housing (20), wherein a sealing material is provided between an inner wall of the housing (20) and the heat-generating component (10), such that heat generated by the heat-generating component (10) can be transferred to the housing (20) via the sealing material; and a heat-exchange cover (30) provided on the opening (22) of the housing (20) to close the opening (22), such that heat generated by the heat-generating component (10) can further be transferred away from the housing (20) via the heat-exchange cover (30). Embodiments according to the present disclosure may improve the reliability of the magnetic apparatus with a high protection grade.

## Description

### FIELD

Example embodiments of the present disclosure generally relate to the field of power conversion, and specifically to a magnetic apparatus and a charging device.

### BACKGROUND

With the popularity of electric vehicles, the importance of charging facilities for charging electric vehicles has become increasingly evident. The charging facilities generate a large amount of heat during the operation. In order to ensure the normal operation of the charging facilities, the charging facilities need to be cooled in a timely and effective manner.

The charging facilities include a power conversion module which functions to convert the mains power connected to the charging facilities into a high voltage to charge the electric vehicle. A core component of the power conversion module is a magnetic core assembly. The magnetic core assembly is a main heat-generating component in the charging facilities, and whether it can be cooled effectively is related to the overall performance of the charging facilities. In the industry, the magnetic core assembly is usually cooled in a liquid-cooling or air-cooling manner. However, the two manners still have drawbacks. Accordingly, it is desirable to provide a more reliable and efficient method to cool the heat-generating component such as the magnetic core assembly in the charging facilities.

### SUMMARY

To at least overcome the problems and/or other potential problems in the field of power conversion in the prior art, example embodiments of the present disclosure provide a magnetic apparatus and a corresponding charging device.

In a first aspect, embodiments of the present disclosure relate to a magnetic apparatus. The magnetic apparatus comprises: a heat-generating component; a housing enclosing an inner space and comprising an opening through which the heat-generating component can enter the inner space so as to be accommodated within the housing, wherein a sealing material is provided between an inner wall of the housing and the heat-generating component, such that heat generated by the heat-generating component can be transferred to the housing via the sealing material; and a heat-exchange cover provided on the opening of the housing to close the opening, such that heat generated by the heat-generating component can further be transferred away from the housing via the heat-exchange cover.

According to embodiments of the present disclosure, the cooling and heat-dissipating effect of the magnetic apparatus may be optimized to improve the reliability of the magnetic apparatus with a high protection grade.

In some embodiments, the magnetic apparatus further comprises first heat-dissipating teeth, the first heat-dissipating teeth being located on a side of the housing opposite to the opening, and configured to transfer the heat generated by the heat-generating component away from the housing.

In some embodiments, a thermally conductive material is disposed between the heat-exchange cover and the heat-generating component to enable the heat generated by the heat-generating component to be transferred to the heat-exchange cover through the thermally conductive material.

In some embodiments, an outer end of the heat-exchange cover is further provided with second heat-dissipating teeth for dissipating heat from the heat-generating component into an environment surrounding the magnetic apparatus.

In some embodiments, the magnetic apparatus further comprises a heat-dissipating pipe disposed on the housing and coupled to the heat-exchange cover, the heat-dissipating pipe being configured to dissipate the heat from the heat-exchange cover into the environment surrounding the magnetic apparatus.

In some embodiments, the heat-generating component is a magnetic core assembly comprising a plurality of magnetic cores magnetically coupled and spaced apart from one another.

In some embodiments, one or more ribs are disposed within the housing and configured such that a distance between the heat-generating component and a rib adjacent to the heat-generating component is less than a predetermined distance.

In a second aspect, embodiments of the present disclosure relate to a charging device. The charging device comprises a magnetic apparatus described above.

### BRIEF DESCRIPTION OF THE DRAWINGS

In order to illustrate technical solutions of embodiments of the present disclosure more clearly, a brief description of the accompanying drawings to be used in the embodiments will be given below. It should be appreciated that the following drawings only show some embodiments of the present disclosure and therefore should not be considered as limiting the scope, and that other relevant drawings may be obtained by those skilled in the art according to these drawings without involving any inventive effort.

Among the figures:
FIG. 1 illustrates a schematic use scenario of a magnetic apparatus according to an example embodiment of the present disclosure;
FIG. 2 illustrates an exploded view of a magnetic apparatus according to an example embodiment of the present disclosure;
FIG. 3A through FIG. 3C illustrate different implementations of a housing in a magnetic apparatus according to embodiments of the present disclosure;
FIG. 4A through FIG. 4C illustrate feasible arrangement manners of magnetic cores in magnetic apparatuses according to embodiments of the present disclosure; and
FIG. 5 illustrates a perspective view of a magnetic apparatus according to another example embodiment of the present disclosure.

### DETAILED DESCRIPTION OF EMBODIMENTS

The principles of the present disclosure will now be described with reference to some example embodiments. It should be appreciated that these examples are only intended to illustrate, and help those skilled in the art to understand and implement the present disclosure, and not to imply any limitation on the scope of the present disclosure. The disclosure described herein may be implemented in various manners in addition to those described below.

In the following depictions and claims, unless otherwise defined, all technical and scientific terms used herein have the same meaning as commonly understood by one of ordinary skill in the art to which the present disclosure belongs.

"One embodiment", "an embodiment", "an example embodiment", etc. mentioned in the present disclosure indicate that the embodiment described may include a specific feature, structure or characteristic, but not each embodiment must include the specific feature, structure or characteristic. Moreover, such phrases do not necessarily refer to the same embodiment. Furthermore, when the specific feature, structure or characteristic is described in connection with an embodiment, those skilled in the art believe that it is within the knowledge of those skilled in the art to apply such feature, structure or characteristic (no natter whether explicitly described) in conjunction with other embodiments

It should be appreciated that while the terms such as "first" and "second" may be used to describe various elements, but these elements should not be limited by these terms. These terms are only used to distinguish one element from another. For example, a first element may be referred to as a second element, and similarly, the second element may be referred to as the first element, without departing from the scope of the example embodiments. As used herein, the term "and/or" comprises any and all combinations of one or more of the listed terms.

In the depictions of the present invention, unless explicitly stated or limited otherwise, the terms "dispose", "provide, "mount", "couple" or "connect" is to be construed broadly, e.g., it may be a fixed connection, a removable connection, or an integral connection; it may be direct connection or direct connection through an intermediate medium, and may be the communication between the interiors of two elements. The specific meaning of the above terms in the present invention may be understood by those having ordinary skill in the art according to specific situations.

The terminology used herein is intended to describe specific embodiments only and is not intended to be limit example embodiments. As used herein, the singular forms "an", "one" and "the" are intended to include plural forms as well, unless the context clearly indicates otherwise. It will be further understood that the terms "include", "comprise", "has", "include" and/or "comprise", when used herein, specify the presence of the stated features, elements and/or components and the like, but do not exclude the presence or addition of one or more other features, elements, components, and/or combinations thereof.

As stated above, the heating-generating component such as the magnetic core assembly is usually cooled in a liquid-cooling or air-cooling manner in the industry. The liquid-cooling manner means taking away the heat generated by the charging facilities by using a liquid as a cooling medium, but this manner has a high cost and is not easily popularized. The air-cooling manner uses air as a medium to directly blow the heat-generating component in the charging facilities. This manner is of a low cost, but has some problems. For example, as air is blown in a longer period of time, the module in the charging facilities might be subject to corrosion. In order to solve such a problem, a sealing material such as a potting glue is often used in the industry to seal the heat-generating component so that the heat-generating component does not come into contact with air to avoid a phenomenon such as corrosion. However, in such a scenario, the problem of heat dissipation from the heat-generating component becomes more prominent.

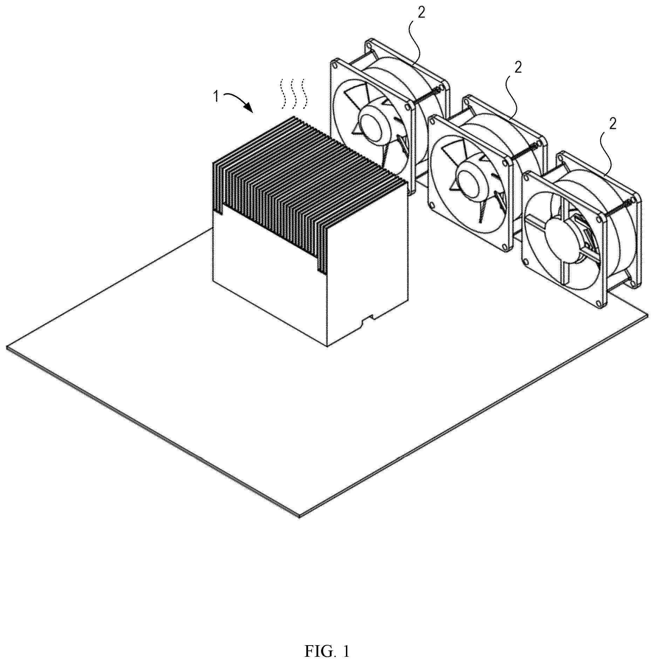

To address at least the above problems, embodiments of the present disclosure provide a magnetic apparatus and a corresponding charging device. A schematic structure of a magnetic apparatus according to an embodiment of the present disclosure is described below with reference to FIG. 1 through FIG. 5.

FIG. 1 illustrates a schematic use scenario of a magnetic apparatus 1 according to an example embodiment of the present disclosure. The magnetic apparatus 1 comprises internally a heat-generating component, such as a magnetic core assembly (not shown), which generates heat during operation. The heat may be dissipated by a component such as a fan 2 in the scenario, to the ambient environment. It is to be understood that FIG. 1 is intended to show a schematic scenario and that an actual application scenario of the magnetic apparatus 1 is not limited to the situation shown in FIG. 1.

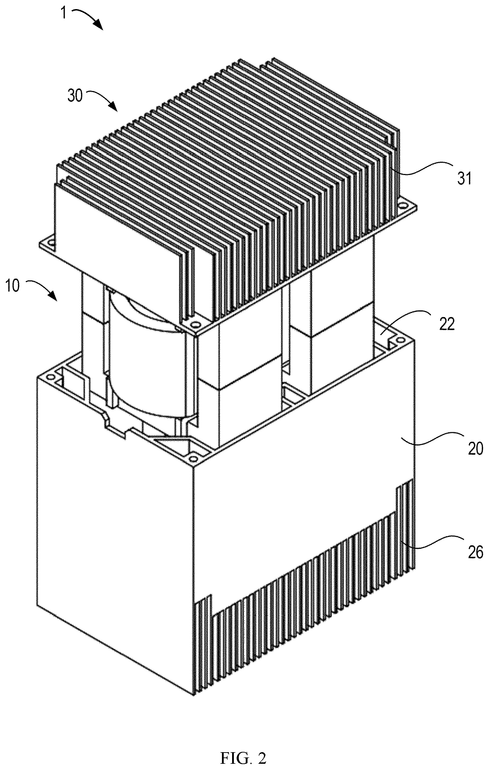

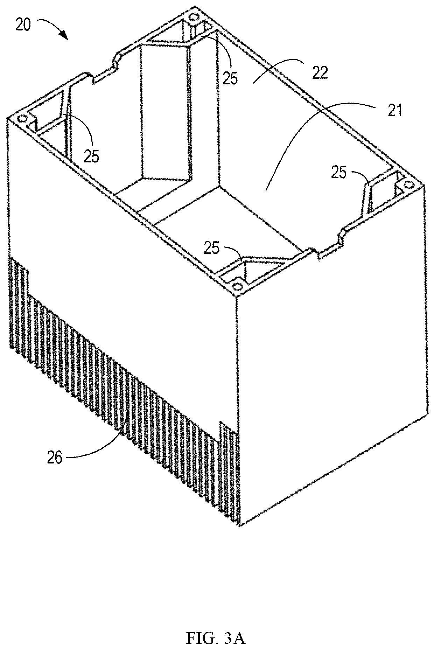

Reference is made below to FIG. 2, which illustrates an exploded view of a magnetic apparatus 1 according to an example embodiment of the present disclosure. As shown in FIG. 2, the magnetic apparatus 1 comprises a housing 20 defining an inner space to receive a magnetic core assembly 10. FIGS. 3A-FIG. 3C illustrate different implementations of the housing 20 in the magnetic apparatus 1 according to embodiments of the present disclosure. In the illustrated embodiments, the housing 20 generally comprises five surfaces to form a rectangular parallelepiped-shaped inner space 21 with an opening 22 located on the top of the housing 20. It should be understood that these are merely illustrative and that the housing 20 may take other shapes in other embodiments.

Referring back to FIG. 2, the magnetic core assembly 10 can enter the inner space 21 via the opening 22 so as to be accommodated by housing 20. The magnetic core assembly 10 operates to convert power and generates a large amount of heat during operation, which needs to be dissipated in time to ensure normal operation of the magnetic apparatus 1. In the context of the present disclosure, the magnetic core assembly 10 may also be referred to as a heat-generating component sometimes. A sealing material, such as a potting glue, is disposed between an inner wall of the housing 20 and the magnetic core assembly 10 such that heat generated by the magnetic core assembly 10 can be transferred to the housing 20 via the sealing material and dissipated to the environment surrounding the magnetic apparatus 1.

Further referring to FIG. 2, the magnetic apparatus 1 further comprises a heat-exchange cover 30 disposed over the opening 22 of the housing 20 to close the opening 22 so that heat generated by the magnetic core assembly 10 can further be transferred away from the housing 20 via the heat-exchange cover 30.

In some embodiments, the magnetic apparatus 1 further comprises first heat-dissipating teeth 26 which are, as shown in FIG. 2, located on a side of the housing 20 opposite to the opening 22, and configured to transfer the heat generated by the heat-generating component 10 away from the housing 20.

According to an embodiment of the present disclosure, the magnetic core assembly 10 as the heat-generating component is fully sealed inside the housing 20. By employing such a fully-sealed structure, the magnetic apparatus 1 of the present disclosure is suitable for high protection grade application. A gap between the magnetic core assembly 10 and the housing 20 may be filled with a sealing material such as a potting glue, to ensure that the magnetic core assembly 10 is fully sealed, thereby achieving a very high protection grade. The heat generated by the magnetic core assembly 10 may be transferred to the housing 20 via the sealing material, and thereby be dissipated in time to the environment surrounding the magnetic apparatus 1.

In some embodiments, a thermally conductive material 24 is disposed between the heat-exchange cover 30 and the magnetic core assembly 10 to enable the heat generated by the magnetic core assembly 10 to be transferred to the heat-exchange cover 30 through the thermally conductive material 24. In other embodiments, the thermally conductive material 24 may also be disposed between the magnetic core assembly 10 and the first heat-dissipating teeth 26 of the housing 20 to enable the heat generated by the magnetic core assembly 10 to be transferred via the thermally conductive material 24 to the first heat-dissipating teeth 26 and thereby be dissipation into the environment surrounding the magnetic apparatus 1.

By means of the thermally conductive material 24 between the heat-exchange cover 30 and the magnetic core assembly 10, the heat from the magnetic core assembly 10 can be more quickly transferred to the heat-exchange cover 30 via the thermally conductive material 24 to be expelled by the heat-exchange cover 30 in time. In this manner, the surfaces of the magnetic core assembly 10 in all directions may be allowed to contact either the thermally conductive material 24 or the sealing material, thereby maximizing the heat dissipation area to meet the high thermal performance requirements for the magnetic apparatus 1.

In one known design, the heat-generating component, such as the magnetic core assembly 10, is mounted into the inner space 21 of the housing 20 through the opening 22, with the thermally conductive material only disposed between the magnetic core assembly 10 and the bottom surface of the housing 20, and without the heat-exchange cover 30 being disposed to cover and close the opening 22. The magnetic apparatus 1 according to the embodiment of the present disclosure is also provided with the heat-exchange cover 30 and the thermally conductive material 24 on the top surface of the housing 20 after the heat-generating component is inserted into the inner space 21 through the opening 22, and heat transfer may be performed on both the top surface and the bottom surface of the housing 20, thereby achieving double-sided cooling to maximize the heat dissipation area. As compared with the single-sided cooling in known designs, double-sided cooling may increase the heat dissipation contact area, thereby reducing the thermal resistance, and enabling the magnetic apparatus 1 to have a better thermal performance in order to improve the operational reliability of the magnetic apparatus 1.

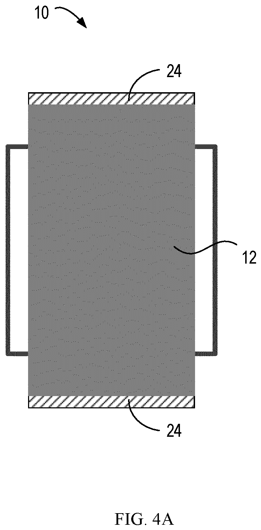

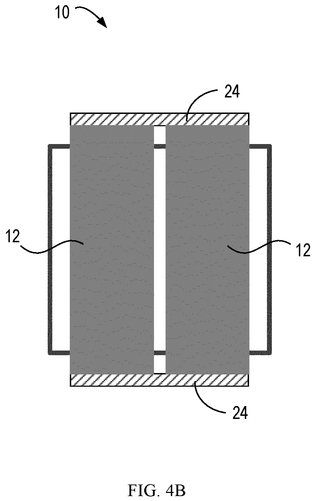

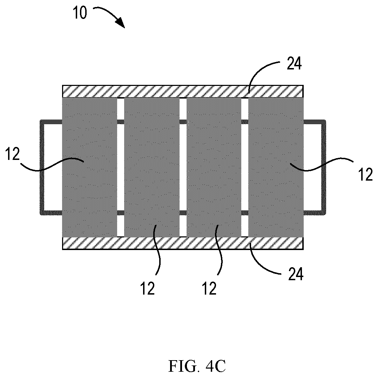

FIG. 4A through FIG. 4C illustrate feasible arrangement manners of magnetic cores in magnetic apparatuses according to embodiments of the present disclosure. In the embodiment illustrated in FIG. 4A, the magnetic core assembly 10 may comprise one magnetic core 12. In the embodiment illustrated in FIG. 4B, the magnetic core assembly 10 may comprise two magnetic cores 12. As compared to the embodiment shown in FIG. 4A, the arrangement manner of the two magnetic cores 12 shown in FIG. 4B may increase the heat dissipation area of the magnetic cores 12, thereby increasing the cooling efficiency. In the embodiment illustrated in FIG. 4C, the magnetic core assembly 10 may comprise four magnetic cores 12. As compared with the embodiment shown in FIGS. 4A-4B, the arrangement manner of the four magnetic cores 12 shown in FIG. 4C may further increase the heat dissipation area of the magnetic cores 12, thereby further increasing the cooling efficiency. These are, of course, merely illustrative and not restrictive. Other numbers of magnetic cores 12 may be used in the magnetic core assembly 10.

According to embodiments of the present disclosure, the use of discrete magnetic cores 12 in the magnetic core assembly 10 may increase the cooling area, and further improve the reliability of the magnetic apparatus 1.

As shown in FIG. 4A through FIG. 4C, in some embodiments, the magnetic cores 12 may have different design sizes and numbers to flexibly suit different profile designs. These magnetic cores 12 may be used alone or may also be embedded in the entirety of a high protection grade power converter.

In some embodiments, referring back to FIG. 2, an outer end of the heat-exchange cover 30 may also be provided with heat-dissipating teeth 31 that function to dissipate heat from the magnetic core assembly 10 into the environment surrounding the magnetic apparatus 1.

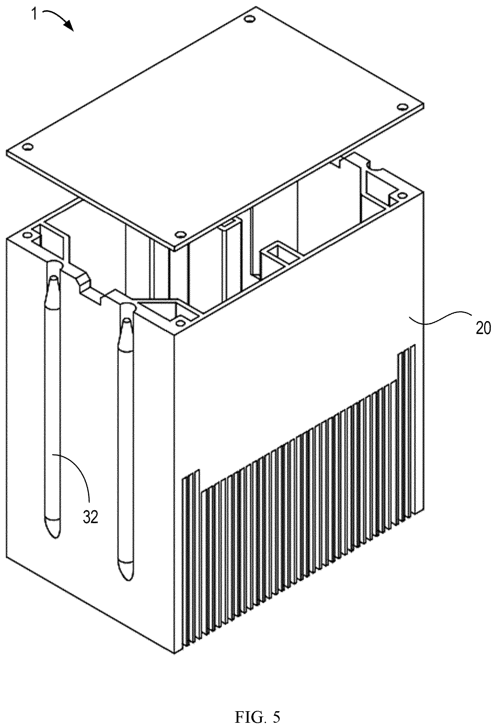

FIG. 5 illustrates a perspective view of a magnetic apparatus according to another example embodiment of the present disclosure. In the embodiment shown in FIG. 5, the magnetic apparatus 1 may further comprise a heat-dissipating pipe 32 which is disposed on the housing 20 and coupled to the heat-exchange cover 30 and configured to dissipate the heat from the heat-exchange cover 30 to the environment surrounding the magnetic apparatus 1.

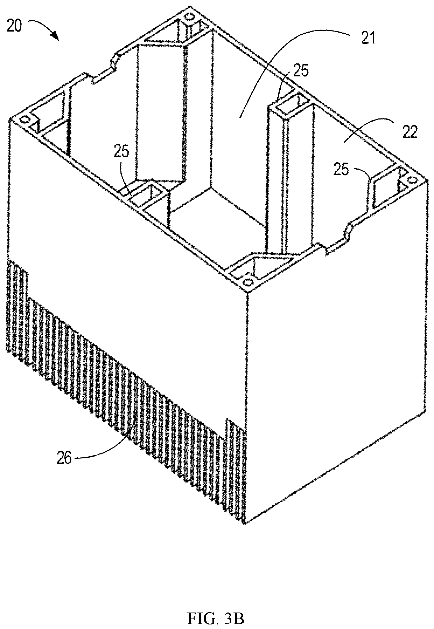

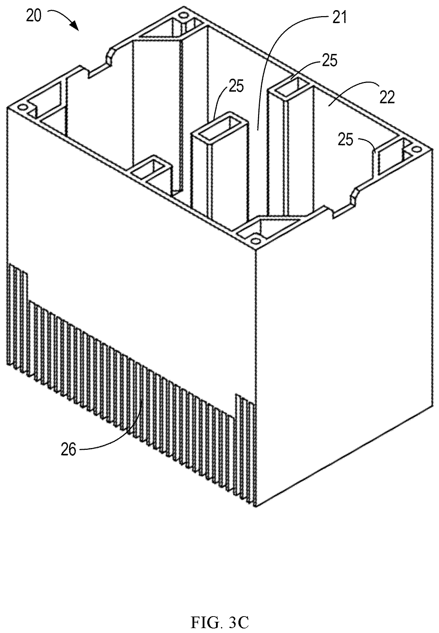

In some embodiments, one or more ribs 25 are disposed within the housing 20, and configured such that a distance between the heat-generating component 10 and a rib 25 adjacent to the heat-generating component 10 is less than a predetermined distance. That is, the ribs 25 are disposed in a way that the distance between them and the adjacent portions of the heat-generating component 10 is sufficiently close. The sufficiently close distance allows the heat-generating component 10 to be as close as possible to the ribs 25 of the housing 20 to ensure heat transfer between the heat-generating component 10 and the ribs 25. For example, in the embodiment shown in FIG. 3A, the ribs 25 of the housing 20 are located near four corners of the housing 20; in the embodiment shown in FIG. 3B, the ribs 25 of the housing 20 are also located near the middle of the edges of the housing 20; in the embodiment shown in FIG. 3C, the ribs 25 of the housing 20 is also located in the middle of the housing 20. In other words, the specific manner of the housing 20 may be designed according to different forms of the magnetic core assembly 10 and matched with the magnetic core assembly 10. Such a profile-designed housing 20 may maximizes the heat exchange area between the housing 20 and the magnetic core assembly 10. In addition, the profile design of the housing 20 also allows for heat dissipation for more different types of magnetic core assemblies 10, thereby implementing more types of magnetic apparatuses 1 to expand the scope of application thereof.

Although embodiments of the present invention are described above in the scenario of the charging facilities of the electric vehicle, it should be appreciated that embodiments of the present invention may also be used in other scenarios and systems, such as solar systems, industrial application, or other power application requiring a high protection grade, without departing from the concepts of the present disclosure. Such embodiments also fall within the scope of the present disclosure.

The specific embodiments described above further describe the objectives, technical solutions and advantageous effects of the present disclosure in more detail. It should be appreciated that what are described above are only specific embodiments of the present disclosure and not intended to limit the protection scope of the present disclosure. Any modifications, equivalent substitutes, improvements and so on made within the scope of the spirit and principles of the present disclosure should all fall within the protection scope of the present disclosure.

## Claims

1. A magnetic apparatus (1), comprising:
a heat-generating component (10);
a housing (20) enclosing an inner space (21) and comprising an opening (22) through which the heat-generating component (10) can enter the inner space (21) so as to be accommodated within the housing (20), wherein a sealing material is provided between an inner wall of the housing (20) and the heat-generating component (10), such that heat generated by the heat-generating component (10) can be transferred to the housing (20) via the sealing material; and
a heat-exchange cover (30) provided on the opening (22) of the housing (20) to close the opening (22), such that heat generated by the heat-generating component (10) can further be transferred away from the housing (20) via the heat-exchange cover (30).

2. The magnetic apparatus (1) according to claim 1, further comprising first heat-dissipating teeth (26), the first heat-dissipating teeth (26) being located on a side of the housing (20) opposite to the opening (22) and configured to transfer the heat generated by the heat-generating component (10) away from the housing (20).

3. The magnetic apparatus (1) according to any of claims 1 to 2, wherein a thermally conductive material (24) is disposed between the heat-exchange cover (30) and the heat-generating component (10) to enable the heat generated by the heat-generating component (10) to be transferred to the heat-exchange cover (30) through the thermally conductive material (24).

4. The magnetic apparatus (1) according to any of claims 1 to 3, wherein an outer end of the heat-exchange cover (30) is further provided with second heat-dissipating teeth (31) for dissipating heat from the heat-generating component (10) into an environment surrounding the magnetic apparatus (1).

5. The magnetic apparatus (1) according to any of claims 1 to 4, further comprising:
a heat-dissipating pipe (32) disposed on the housing (20) and coupled to the heat-exchange cover (30), the heat-dissipating pipe (32) being configured to dissipate the heat from the heat-exchange cover (30) into the environment surrounding the magnetic apparatus (1).

6. The magnetic apparatus (1) according to any of claims 1 to 5, wherein the heat-generating component (10) is a magnetic core assembly comprising a plurality of magnetic cores (12) magnetically coupled and spaced apart from one another.

7. The magnetic apparatus (1) according to any of claims 1 to 6, wherein one or more ribs (25) are disposed within the housing (20) and configured such that a distance between the heat-generating component (10) and a rib (25) adjacent to the heat-generating component is less than a predetermined distance.

8. A charging device, comprising a magnetic apparatus (1) according to any of claims 1-7.
